# EUROPEAN PATENT SPECIFICATION

(11) **EP 4 287 793 B1**
(45) Date of publication and mention of the grant of the patent: **19.08.2026**
(21) Application number: 22177310.4
(22) Date of filing: 03.06.2022
(51) Int. Cl.: H05K 5/00

(54) **HOUSING ASSEMBLY, ASSEMBLED PART, AND METHOD FOR ASSEMBLING A SUBSTRATE IN A HOUSING**
GEHÄUSEANORDNUNG, ZUSAMMENGEBAUTES TEIL UND VERFAHREN ZUM ZUSAMMENBAUEN EINES SUBSTRATS IN EINEM GEHÄUSE
ENSEMBLE BOÎTIER, PIÈCE ASSEMBLÉE, ET PROCÉDÉ D'ASSEMBLAGE D'UN SUBSTRAT DANS UN BOÎTIER

(43) Date of publication of application: 06.12.2023
(73) Proprietor: TE Connectivity Germany GmbH, 64625 Bensheim (DE); Te Sensores, S. de R.L. de C.V., Hermosillo SON (MX)
(72) Inventor: GLASER, Karlheinz, 64625 Bensheim (DE); MATA VILCHIS, Juan Antonio, 54060 Tlalnepantla (MX)
(74) Representative: Grünecker Patent- und Rechtsanwälte PartG mbB

(56) References cited:
- CN-A- 112 839 455
- DE-A1- 102015 117 223
- DE-B3- 102020 211 730
- KR-A- 20220 000 090
- US-A1- 2006 044 768
- US-A1- 2011 168 441
- US-A1- 2022 030 737

## Description

The invention relates to a housing assembly, an assembled part, and a method for assembling a substrate in a housing.

A housing assembly is an assembly of parts, e.g. a base and a cover, which together form, when assembled, a housing. A housing is an exterior case or enclosure used to protect an interior mechanism, e.g. a substrate for carrying delicate integrated electrical fittings. Thus, the housing prevents the interior mechanism, e.g. a substrate, from being fouled by outside media, e.g. debris.

In particular, the interior part, e.g. the substrate may comprise an electronic component used for a sensor. In particular, the sensor application may define requirements for the housing when assembled. In more detail, sensors, e.g. sensors for measuring a temperature, a body's specific force, angular rate, an orientation of the body, or the like, may be used under harsh environmental conditions. For example, a sensor may be used in a gearbox, e.g. of a vehicle or a work tool, or a sensor may be used in a transportation box, e.g. measuring the environmental conditions during shipping.

For allowing the sensor to be operated, the housing needs to be designed in view of such harsh environmental conditions, in particular the housing may need to protect an interior mechanisms, e.g. the substrate, from external influences. External influences are e.g. structural stress and/or potential physical, thermal, chemical, biological or radiational damages from the surrounding environment, and/or against ingression of media such as fluids or particles.

In more detail, the harsh environmental conditions may be temporary and/or periodic such that the housing and interior mechanism, e.g. a substrate, may experience thermal variations and or mechanical loads such as vibrations and shocks. Thus, the housing may needs to be designed to be sufficiently robust to be protective in view of the variable harsh environmental conditions. In particular, stress can be caused by change of temperature in the applications by different coefficient of thermal extension (CTE) factors of the components, e.g. the base and the cover may have a different CTE than the interior part, e.g. the substrate. This effect is leading to have a strain release in all directions of the interconnection areas.

Further, various fabrications techniques are known to manufacture a housing. However, the technics may have drawbacks in view of enclosing an interior mechanism, e.g. a substrate. For example, ultrasonic welding can stress the overall assembly in a critical way, in particular by destroying the electrical components hold by the substrate. Clipping a cover to a base may leading in complex cover geometries in view of additional necessary sealing element.

Further, a housing for an interior mechanism, e.g. a substrate, may require a plurality of mounting steps, additional components, and/or providing during the mounting additional materials.

DE 10 2020 211 730 B3 discloses a housing for a substrate. Further housing arrangements are disclosed in DE 10 2015 117 223 A1, US 2011/168441 A1, US 2022/030737 A1.

KR 2022 0000090 A1 discloses a laser welded connection

At least one of objects discussed above is solved by the independent claims. Advantageous embodiments are solved by the dependent claims.

The present invention is set out in the appended claims.

The present disclosure proposes a housing assembly comprising a base and a cover. The base holds a substrate, e.g. a printed circuit assembly (PCB). Further, the cover comprises a fixation means protruding from the cover for deforming the substrate. Thus, when assembling the cover to the base, two process steps are performed at the same time, namely the cover is mounted on the base forming the assembled housing enclosing the substrate. At the same time, the fixation means deforms the substrate, and thus, fixes the substrate in the enclosed housing.

Thus, the housing assembly allows minimizing the cost-to-function by a minimum of components/materials and process-steps.

In more detail, the following description relates to a housing assembly for enclosing and clamping a substrate in a chamber.

As used herein, a housing assembly is an assembly of parts, the parts comprising a base and a cover, which together form, when assembled, a housing. The housing assembly protects a substrate by mounting the base to the cover. The housing assembly encloses the substrate. Enclosing means that the assembled parts build walls around the substrate. In other words, the assembled parts form the chamber wherein the substrate is placed. Such an arrangement allows preventing the substrate from being fouled by outside media.

As used herein, a substrate describes the base material on which processing is conducted. In particular, the substrate is used for carrying an electronic component. In more detail, the substrate is used to form a printed circuit board (PCB) or a printed circuit board assembly (PCBa). A typical substrate might be rigid such as an epoxy or glass, onto which a coating might be deposited.

As used herein, clamping the substrate in the chamber means that the substrate is hold fastened or fixed in the camber. In other words, the substrate cannot move in the chamber when clamped. Such an arrangement prevents that the substrate moves relative to the housing when the housing experiences thermal variations and/or mechanical loads such as vibrations and shocks.

The housing assembly comprises the base having a protruding holder for holding the substrate in the chamber. In particular, the base being an accommodation such as a recessed part having a bottom wall and side walls protruding from the bottom wall for receiving and partly enclosing the substrate.

Further, the holder is for example a plateau, a pin or a similar structure protruding from the base, e.g. from the bottom or the side wall. Such an arrangement enables that the substrate is held at least partially spaced apart from a bottom surface of the base. In other words, the holder protrudes in the chamber.

According to an example, the base forms the recessed part with the bottom wall forming the bottom surface and side walls. The bottom surface being for example a generally plane surface and the holder, e.g. the plateau shaped holder or a holder formed by on ore more pins, protrudes in the direction of the surrounding wall from the bottom surface. Thus, the substrate rests on the holder and a gap is formed between the substrate and the bottom surface. In other words, the substrate does not rest on the bottom surface but is held spaced apart from the bottom surface by the holder. Alternatively, the holder may protrude from the side wall of the base which allows also forming a gap between the substrate and the bottom surface.

Further, the housing assembly comprises a cover having a top surface opposing the bottom surface. According to an example, the cover may be a plate for being mounted to the side wall of the base. Alternatively, the cover may comprises a cover wall and a cover side wall protruding from the cover side wall, the cover side wall for being mounted to the side wall of the base.

In addition, to assemble the housing, i.e. enclosing the substrate, the top surface is moved towards the bottom surface. To close the housing, the cover may for example be welded, screwed, welded or clipped to the base. In particular, each of the mounting technics comprises a translation of the top surface in the direction of the bottom surface thereby closing a gap between the cover and the base, and thus, enclosing the substrate.

Further, the cover comprises a fixation means, e.g. a pin such as a columnar structure, protruding from the cover in the direction of the bottom surface. The fixation means deforms the substrate when the top surface is moved towards the bottom surface, i.e. when the cover encloses the substrate. In other words, the fixation means is arranged on the cover so that it protrudes in the chamber. According to an example, in case the base being a recessed part having a bottom wall and side walls, the fixation means protrudes in the space that is enclosed by the base.

The fixation means enables that within one process step, namely moving the cover towards the base, two process steps are performed, namely enclosing the substrate and at the same time deforming the substrate so that the substrate is clamped between the fixation means and the holder. In particular, the gap formed between the base and the bottom surface allows that the substrate elastically deforms. In other words, the fixation means acts as a spring bias clamping the substrate in the chamber.

In other words, a spring-load is applied by a partly deformation of a decoupled section of the substrate, e.g. the PCBa or the PCB, by a geometry which is realized by the cover of the housing. The pressing features and the deformation for deforming the substrate, e.g. the PCB, over a fixation part, which is also referred to as deformation area or spring loaded area, can be calculated according to the IPC standards in order to keep the integrity of all components.

According to the present invention, the housing assembly comprises a deformable part for sealing the assembled housing. As used herein, the deformable part enables that the deformable part undergoes a plastic or elastic deformation.

For example, by welding the cover to the base, the deformable part may be the part that transforms to the weld that undergoes a plastic, i.e. non-reversible deformation. Alternatively, by screwing or clipping the cover to the base, the deformable part may be a sealing element, e.g. a sealing ring, which elastically deforms when assembling housing.

Further, the deformable part is for being compressed when moving the top surface towards the bottom surface. According to the present invention, the deformable part being compressed in the direction of moving the top surface towards the bottom surface.

According to the present invention, in particular when using a welding process, at least one of the base or the cover comprises the deformable part, the deformable part being arranged at the edge of the base or the cover. Thus, an edge of the cover or the base is deformed by the welding process.

Alternatively, according to an embodiment not covered by the claims, the deformable part can be an additional part, e.g. a sealing element, which is arranged between the base and the cover. Such a sealing element may be used when for example clipping or screwing is used for mounting the cover to the base.

The deformable part enables that within one process step, namely moving the cover towards the base, three process steps are performed, namely enclosing the substrate, deforming the substrate so that the substrate is clamped between the fixation means and the holder, and at the same time sealing the housing. In particular, the deformable part defines by its construction by how much the top surface is moving towards the bottom surface. This additionally defines by which amount the substrate elastically deforms. In other words, the deformation part acts as a measure for defining the spring bias applied to the substrate.

According to an aspect, the deformable part comprises a thermoplastic material for melting when heated. Thus, the assembled housing comprises a weld or fusion zone for sealing the housing.

As used herein, a thermoplastic, or thermosoft plastic, is a plastic polymer material that becomes pliable or moldable at a certain elevated temperature and solidifies upon cooling. The polymer chains associate by intermolecular forces, which weaken rapidly with increased temperature, yielding a viscous liquid. In this state, thermoplastics may be reshaped and are typically used to produce parts by various polymer processing techniques such as injection molding, compression molding, calendaring, and extrusion.

As used in the present disclosure, welding is a fabrication process that joins materials, usually metals or thermoplastics, by using high heat to melt the parts together and allowing them to cool, causing fusion. Welding is distinct from lower temperature techniques such as brazing and soldering, which do not melt the base metal. The fusion zone allows sealing of the chamber in the housing. In particular, the fusion zone is stable even under harsh environmental conditions.

Thus, providing a deformable part comprising a thermoplastic enables that the number of parts is reduced. In particular, at least one of the cover and the base may comprise the thermoplastic material thereby additionally being adapted for welding.

In addition, the process step of moving the cover towards the base enables a particularly strong welded connection. In particular, during the welding process, pressure is applied to the parts. Thus, a particular strong weld it formed.

According to the present invention, one of the cover and the base is transparent for guiding light to the deformable part for joining the base to the cover by laser welding.

As used herein, transparent means that a part of the radiation emitted by a radiation source such as a laser is guided through the cover or the base to the deformable part. For example, down to 10 % of the radiation emitted by radiation source may be guided through the cover or the base which, which thus is transparent. The material and the thickness of the cover or the base may be chosen so that the cover or the base becomes transparent for a radiation source having for example a wavelength larger equal 630 nm and less equal 1100 nm.

This transparent part allows for radiation welding such as laser or electron beam welding. Laser welding is a welding technique used to join pieces of metal or thermoplastics by the use of a laser. The beam provides a concentrated radian energy source, allowing for narrow, deep welds and high welding rates. The process is frequently used in high volume applications using automation, as in the automotive industry.

Equipment for e.g. thermoplastic Laser-welding using e.g. red or infrared light, which covers wavelength larger equal 630 nm and less equal 1100 nm, e.g. λ = 980 nm wave length. Such lasers are well established in the market and thus is a readily available technology that is globally available.

This enables for using a welding appliance, which provides two functions, namely heating the deformable part to weld the cover to the base. At the same time, the welding appliance can comprise means for pressing the cover to the base. Typically, welding appliance have implemented both functions, and thus, cost-to-function is minimized.

In other words, during operation of the radiation source, e.g. the laser, the cover can be moved into direction of the base. This process is also referred to as setting. Thus, the housing closes tight and in a mechanically robust manner.

According to a further aspect, the fixation means protrudes from the top surface. For example, the fixation means protrudes in the direction of the normal of the top surface, which for example is a flat surface. Such an arrangement allows a particularly stable configuration.

According to a further aspect, the holder protrudes from the bottom surface. For example, the holder protrudes in the direction of the normal of the bottom surface, which for example is a flat surface. Such an arrangement allows a particularly stable configuration.

Further, the following description relates to a kit for assembled part, the kit comprising a substrate for carrying an electronic component and a housing assembly as describe above for enclosing the substrate.

The substrate, which has been described above, comprises a holding surface and an opposing fixation surface. In particular, the substrate is a flat part such as PCB. For example, the substrate comprises an insulating layer for affix electronic components in designated locations. Further, the substrate can comprise a contacting layer for provide reliable electrical connections (and also reliable open circuits) between the component's terminals in a controlled manner.

Further, the holding surface comprises a holding part for being hold by the holder of the base. In particular, the holding part is part of the insulating layer.

Further, the fixation surface comprising a fixation part for being deformed by the fixation means of the cover for fixing the substrate in the chamber. In particular, the fixation part is a part of the insulating layer.

Thus, the substrate allows for being clamped in the housing. As described above, the pressing features and the deformation for deforming the substrate, e.g. the PCB, over the fixation part can be calculated according to the IPC standards and is defined by the geometry of the housing.

According to an aspect, the substrate comprises an epoxy.

As used herein, epoxy is the family of basic components or cured end products of epoxy resins. In particular, an insulating layer of the substrate comprises or consists of epoxy. The insulating layer, which is used for carrying electronic components, has thus a low tendency for creeping. As used herein, creep (sometimes called cold flow) is the tendency of a solid material to move slowly or deform permanently under the influence of persistent mechanical stresses. It can occur as a result of long-term exposure to high levels of stress that are still below the yield strength of the material. Creep is more severe in materials that are subjected to heat for long periods and generally increases as they near their melting point.

In particular, the substrate, e.g. a PCBa or PCB, comprising epoxy has the character of having a low or no creeping effect, which has for example proven by interconnections used for substrates comprising epoxy like press-fit connections.

Thus, using a substrate comprising an epoxy enables a particularly long-term stability of the parts.

In particular, the tendency of creeping of the substrate is lower than the tendency of creeping of the housing element, in particular in the case of the housing comprising thermoplastic materials.

According to an aspect, the substrate comprises a recess. As used herein, a recess is a part of the substrate that is thinner, for example a through hole, than the rest of the substrate, forming a space.

Further, the recess being arranged abutting to the fixation part. As used herein, abutting means that the recess is next to the fixation part, in particular, to have one side touching the side of the fixation portion. In other words, an electric component free area is formed between the fixation part and the recess, in particular the electric component free area only comprises isolating material.

Thus, the electronic component is protected from stress caused by deformation of the fixation part of the substrate.

According to an aspect, the substrate comprises material having a lower coefficient of thermal expansion (CTE) than the material comprised in the parts of the housing assembly.

As generally known, thermal expansion decreases with increasing bond energy, which also has an effect on the melting point of solids, so, high melting point materials are more likely to have lower thermal expansion. In particular, for enabling that the housing parts are joint by a welding process, the housing parts comprise a material such as a thermoplastic, which melts, for example at a temperature of about 200° C to 400° C. On the other hands, the substrate is in particular a thermoset such as an epoxy with has particularly strong bonds. Cured thermosets usually do not melt and have compared to a housing comprising thermoplastics for welding a lower thermal expansion.

The above described arrangement allows to clamp the substrate by the housing even in a case of materials having a different CTE. In particular, upon heating, the housing parts expand. In view of the fixation means and the holder protruding from the top surface and the bottom surface respectively, the complete housing experiences the thermal expansion. In view of this geometric configuration, the fixation of the substrate does not change upon temperature changes.

Further, the following description relates to an assembled part comprising a housing and a substrate for holding an electronic component in a chamber. For the description of the housing, the substrate, the electronic component, and the chamber is referred to the above description.

Further, the substrate of the assembled part comprises a holding surface and an opposing clamping surface. For the description of the holding surface and an opposing clamping surface is referred to the above description.

Further, the housing enclosing the substrate comprises a base and cover. For the description of the base and the cover is referred to the above description.

The base has a protruding holder holding the substrate at a holding part arranged at the holding surface, the holder protruding from the base so that the substrate is held at least partially spaced apart from a bottom surface of the base thereby forming a gap between the substrate and the base. For the description of the holder, the holding part, the bottom surface, and the gap is referred to the above description. Notably, the holding surface is at least partly facing the bottom surface thereby forming the gap.

The cover has a top surface opposing the bottom surface, the cover being mounted to the base thereby enclosing the substrate. For the description of the top surface is referred to the above description.

Further, the cover comprises a fixation means protruding from the cover in the direction of the bottom surface, the fixation means deforming a fixation part arranged at the fixation surface so that the substrate is clamped in the assembled part. For the description of the fixation means and the fixation part is referred to the above description.

In particular, the assembled part can be realized using the kit described above.

According to an aspect, the housing of the assembled part comprises a weld, the weld sealing the chamber formed by the housing in which the substrate is clamped from ingression of media. For a description of the weld is referred to the above description. In particular, the weld comprises material of at least one of the cover and the base.

According to a further aspect, the assembled part comprises a deformable part for sealing the assembled housing, the deformable part being compressed. For a description of the deformable part is referred to the above description. In particular, the deformable part comprises a thermoplastic material for melting when heated.

According to a further aspect, at least one of the cover and the base of the assembled part is transparent for guiding light to the deformable part for joining the base to the cover by radiation welding. For a description of the transparent parts is referred to the above description.

According to a further aspect, the fixation means protrudes from the top surface and/or the holder protrudes from the bottom surface.

According to a further aspect, the substrate of the assembled part comprises a recess, the recess being arranged abutting to the fixation part for protecting the electronic component from stress caused by deformation of the fixation part. For a description of the recess is referred to the above description.

Further, the following description relates to a method for assembling a substrate in a housing, the method comprising the steps of:
holding a substrate in a base of the housing by a protruding holder for forming a gap between the substrate and a bottom surface of the base;
enclosing the substrate being hold in the base by moving a cover of the housing to the base thereby assembling the housing;
deforming the substrate being hold in the base by moving a fixation means protruding from the cover in the direction of the bottom surface;
wherein the steps of enclosing and deforming the substrate are executed simultaneously by moving a top surface of the cover, the top surface opposing the bottom surface, in the direction of the bottom surface.

In particular, the method relates to assembling the kit described above. For further details of the method steps is referred to the above.

As used herein, simultaneously means that the process steps are performed at the same time and are caused by the same process step, namely moving the top surface of the cover in the direction of the bottom surface.

According to the present invention, the method comprises welding the base to the cover for assembling the housing. For the description of the process of welding is referred to the above description. In particular, the step of wherein the steps of welding the housing, enclosing the substrate, and deforming the substrate are executed simultaneously.

According to the present invention, the method comprises applying external force to at least one the cover and the base portion for moving the top surface to the bottom surface. As used herein, applying external force means that the top surface is actively moved to the bottom surface. For example, as described above, during operation of a radiation source, e.g. a laser, the cover can be moved into direction of the base by applying external force. This process is also referred to as setting. Thus, the housing closes tight and in a mechanically robust manner.

According to the present invention, the method comprises guiding radiation trough at least one the cover and the base portion for welding the base portion to the cover. As used herein, guiding radiation trough a part means that the part is transparent. For the description of the transparent part is referred to the above description. Such a configuration enables that a welding appliance can be used, which provides two functions, namely heating the deformable part to weld the cover to the base. At the same time, the welding appliance can comprise means for pressing the cover to the base. Typically, welding appliance have implemented both functions, and thus, cost-to-function is minimized.

The invention will now be described in greater detail and in an exemplary manner using advantageous embodiments and with reference to the drawings. The described embodiments are only possible configurations in which, however, the individual features as described above can be provided independently of one another or can be omitted.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. The described embodiments are merely possible configurations and it must be borne in mind that the individual features as described above can be provided independently of one another or can be omitted altogether while implementing this invention. Further features and advantages will become apparent from the following more particular description of the various embodiments of the invention, as illustrated in the accompanying drawings, in which like references refer to like elements, and wherein:
- **FIG. 1**: is a schematic of a kit according to one aspect before assembling;
- **FIG. 2**: is a schematic of the kit of Fig. 1 after assembling;
- **FIG. 3**: is a schematic of a detail of Fig. 1 showing a substrate according to one aspect;
- **FIG. 4**: is an exploded view of a kit according to an example;
- **FIG. 5**: is a sectional view of Fig. 4;
- **FIG. 6**: is an exploded view of a substrate and a cover of Fig. 4;
- **FIG. 7**: is a top view of the substrate of Fig. 4;
- **FIG. 8**: is a further view of the substrate of Fig. 4;
- **FIG. 9**: is a view of the cover of Fig. 4;
- **FIG. 10**: is a sectional view of the kit of Fig. 4 before assembling; and
- **FIG. 11**: is a sectional view of the kit of Fig. 4 after assembling.

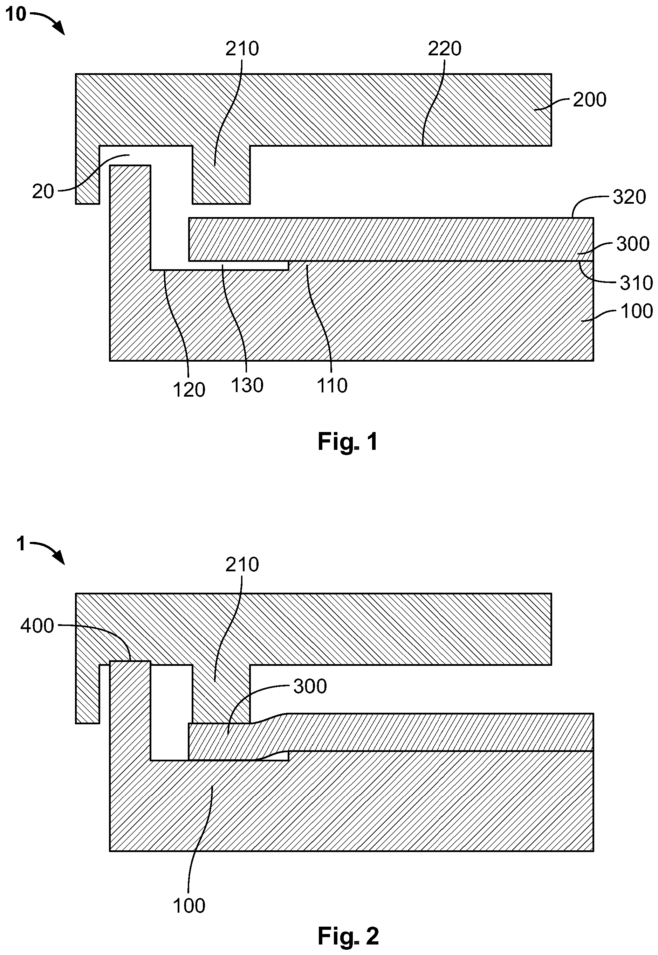

The present invention will now be explained in more detail with reference to the Figures. Referring to Fig. 1, a schematic of a kit 10 according to one aspect is described.

In particular, the kit 10 for an assembled part comprises a substrate 300 for carrying an electronic component. Further, the kit 10 comprises a housing assembly for enclosing the substrate.

The housing assembly comprises a base 100. The base 100 has a protruding holder 110 for holding the substrate in the chamber, the holder protruding from the base so that the substrate is held at least partially spaced apart from a bottom surface 120 of the base thereby forming a gap 130.

For example, as shown in Fig. 1, the base 100 is a recessed part with bottom wall and a side wall protruding from the bottom wall. The holder 110 is a plateau arranged in a central part of the bottom wall. In other words, the gap is arranged at a circumferential part of the substrate. This enables that the later to be described fixation means 210 can clamp a circumferential part of the substrate 300.

Alternatively, the holder may be a pin, i.e. a columnar structure, a rip, or the like. Further, the base may only a plate without side walls. Further, the holder may be arranged at an edge part base.

The substrate 300 may be mounted to the holder, e.g. by using press fit pins, gluing, clipping, screwing the substrate to the bottom wall. Alternatively, the substrate may be lay on the holder without being fixed to the holder.

Further, the cover 200 has a top surface 220. The top surface 220 opposes the bottom surface 120. In other words, the top surface 220 and the bottom surface 120 are facing the chamber of the housing.

The cover 200 is for enclosing the substrate 300 by moving the top surface towards the bottom surface. In particular, Fig. 1 shows the parts before assembling. A space 20 can be identified between the cover 200 and the base 100.

Further, the cover comprises the fixation means 210 protruding from the cover 200 in the direction of the bottom surface 120.

As shown in Fig. 2, showing an assembled part 1 formed by assembling the kit 10 of Fig. 1, the fixation means 210 deforms the substrate 300. Thus, the fixation means 210 clamps the substrate is in the assembled housing when the cover encloses the substrate.

For example, as shown in Figs. 1 and 2, the cover 100 is a recessed part with top wall and a side wall protruding from the top wall. The fixation means 210 is a pin arranged in a circumferential part of the top wall. Thus, the fixation means can clamp a circumferential part of the substrate.

Alternatively, the fixation means may be a rip, a plateau, or the like. Further, the cover may only be a plate without side walls. Further, the fixation means may be arranged at a central part of the cover.

As shown in Figs. 1 and 2, the substrate comprises a holding surface 310 and an opposing fixation surface 320. In other words, the substrate is a flat body. As used herein, a flat body is geometric body in the form of whose lateral dimension, e.g. a radius of a cylinder, is many times, e.g. 10 times, greater than its thickness.

Further, the holding surface 120 comprises a holding part for being hold by the holder 110 of the base. For example, as shown in Figs. 1 and 2, the holding part is a central part of the substrate. Further, the fixation surface 320 comprising a fixation part for being deformed by the fixation means 210 of the cover for fixing the substrate in the chamber. In particular, as shown in Fig. 1, the fixation means 210 is not in contact with the fixation part, and thus, the substrate is not deformed.

Further, as shown in Fig. 2, the fixation means 210 is in contact with substrate 300 and the substrate is deformed. Thus, the substrate 300 is clamped in the housing.

Further, the housing assembly comprises a deformable part for sealing the assembled housing. For example, the deformable part may be a sealing arranged in the space 20. Additionally or alternatively, the deformable part may be an edge part of the side wall of the base abutting to the space 20. Additionally or alternatively, the deformable part may be a part of the cover abutting to the space 20.

The deformable part is adapted for being compressed when moving the top surface towards the bottom surface. In other words, when the parts of Fig. 1 are assembled, as shown in Fig. 2, the deformable part 400 is compressed and arranged at the connection of the base 100 and the cover 200.

Further, the deformable part may comprise a thermoplastic material for melting when heated. In particular, the deformable can be for example an edge part of the side wall of the base abutting to the space 20 or a part of the cover abutting to the space 20. Thus the cover can be welded to the base without the need of providing a further material, e.g. an adhesive. In other words, a part of at least one of the cover and the base is melting during heating, thereby deforming.

Further, at least one of the cover 200 and the base 100 is made from a transparent material for guiding light to the deformable part for joining the base to the cover by radiation welding. For example, in Fig. 1 the cover 200 is made from a transparent material. Thus, the weld 400 can be generated. Further, the weld 400 can be protected by the side wall of the cover 200 form external influences.

Further, as shown in Figs. 1 and 2, the fixation means 210 protrudes from the top surface 220. Further, holder 110 protrudes from the bottom surface 120. Alternatively, according to a not shown solution, the holder may for example protrude from a side wall of the base.

Further, as shown in Figs. 1 and 2, the fixation part is an edge part of the substrate. In particular, the fixation part surrounds the central part. Notably, the fixation part and the holding part are not overlapping in a dimension having as a normal the axis of moving the top surface towards the bottom surface. This enables the deformation of the substrate. For the same reasons, the holder and the fixation means are arranged shifted in the housing so that fixation means moved in the direction of the gap when the top surface moves towards the bottom surface.

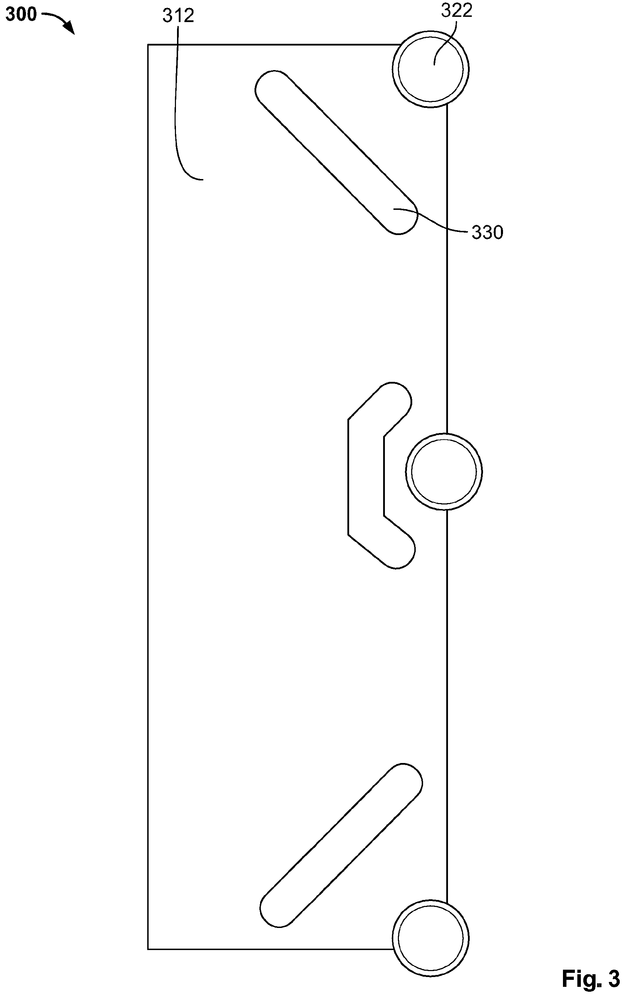

Further details of the substrate are shown in Fig. 3. In particular, the substrate 300 comprises the fixation part 322 and the holding part 312. Between the fixation part 322 and the holding part 312 a recess 330 is formed. In particular, the recess 330 is in the form of long hole or a hole comprising a plurality of long holes.

Thus, the substrate is divided in sections having different functionality. A central part is for carrying an electronic component. This part is not or nearly not deformed. This central part comprises the holding part 312.

Further, the substrate comprises an edge part for being deformed. This part comprises the fixation part 322. This part experiences the stress for clamping the substrate in the housing.

Further, a recess can be arranged abutting to the fixation part for protecting the electronic component from stress caused by deformation of the fixation part. In particular, the recess can be arranged between the central part and the edge part. For example, the pin like fixation means can locally deform the substrate. Providing recesses 330 enables reducing the stress effects thereby allowing to increase the central part which can carry the electronic components.

Further, as discussed above, the substrate may comprise an epoxy. Further, as discussed above, the substrate can comprise material having a lower coefficient of thermal expansion than the material comprised in the parts of the housing assembly.

The assembled part as shown in Fig. 2 comprises a substrate, for example, the substrate shown in Fig. 3. In particular, the assembled part comprises a housing and the substrate 300 for holding an electronic component in a chamber. The substrate comprises a holding surface 310 and an opposing clamping surface 320. The housing enclosing the substrate. The housing comprises the base 100 having a protruding holder 110 holding the substrate at a holder part 312 arranged at the holding surface 310, the holder protruding from the base so that the substrate is held at least partially spaced apart from a bottom surface 120 of the base thereby forming a gap between the substrate and the base. Further, the hosing comprises the cover 200 having a top surface 220 opposing the bottom surface, the cover being mounted to the base thereby enclosing the substrate. Further, the cover comprises the fixation means 210 protruding from the cover in the direction of the bottom surface, the fixation means deforming a fixation part 322 arranged at the fixation surface so that the substrate is clamped in the assembled part.

In particular, the assembled part can comprise a weld 400. The weld seals the chamber formed by the housing in which the substrate is clamped from the ingression of media.

For assembling the parts as shown in Fig. 1, the following method may be performed. In particular, the steps enable assembling a substrate 300 in a housing. As a first step, which is shown in Fig. 1, the substrate is hold in a base 100 of the housing by a protruding holder 110 for forming a gap 130 between the substrate and a bottom surface 120 of the base.

Further, as shown in Fig. 2, the substrate is enclosed by moving the cover 200 of the housing to the base 100 thereby assembling the housing. Further, the substrate is deformed by moving the fixation means 210 protruding from the cover in the direction of the bottom surface. As shown in Fig. 2, the steps of enclosing and deforming the substrate are executed simultaneously by moving a top surface 220 of the cover, the top surface opposing the bottom surface, in the direction of the bottom surface.

Further, the method may comprise the step of welding the base to the cover for assembling the housing. Thus, the weld 400 is sealing the interior of the housing. In particular, an external force is applied to at least one the cover and the base portion for moving the top surface to the bottom surface. Thus, the molten material, which is heated during the welding process, is compressed. Further, for enabling the welding step, radiation can be guided trough at least one the cover and the base portion for heating at least one of the base portion and the cover to weld the base station to the cover.

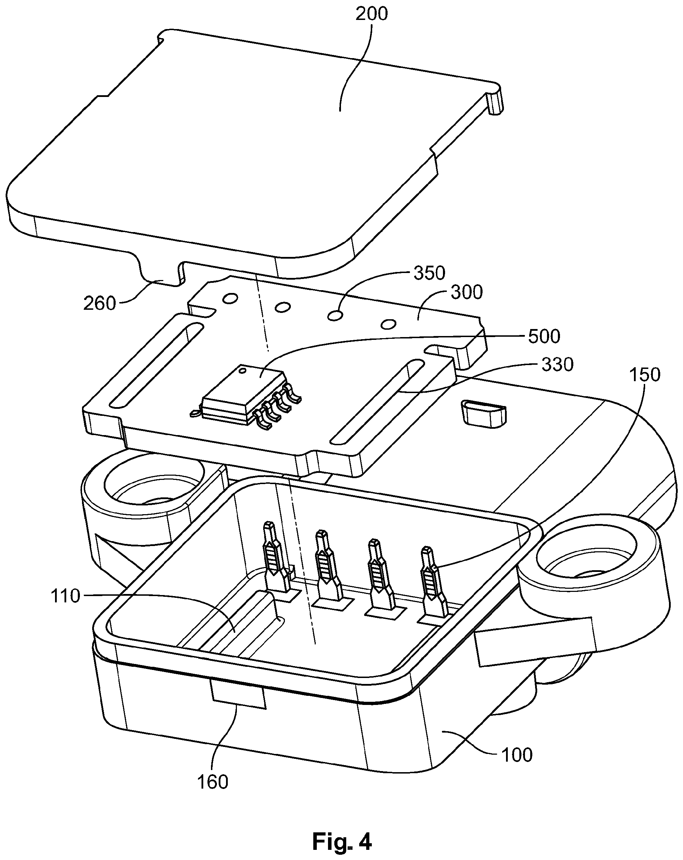

An example of a kit is shown in Fig. 4. In particular, the kit comprises a base 100, a substrate 300 with an electronic component 500, and a cover 200.

The base 100 comprises a rip shaped holder 110. Further, the base may comprise press-fit pins 150 for electrically and/or mechanically connecting the substrate 300 by entering in press-fit opening 350. Further, the base may comprise an opening 160 for receiving a clip 260 of the cover 200. Further, the substrate 300 comprises a recess 330.

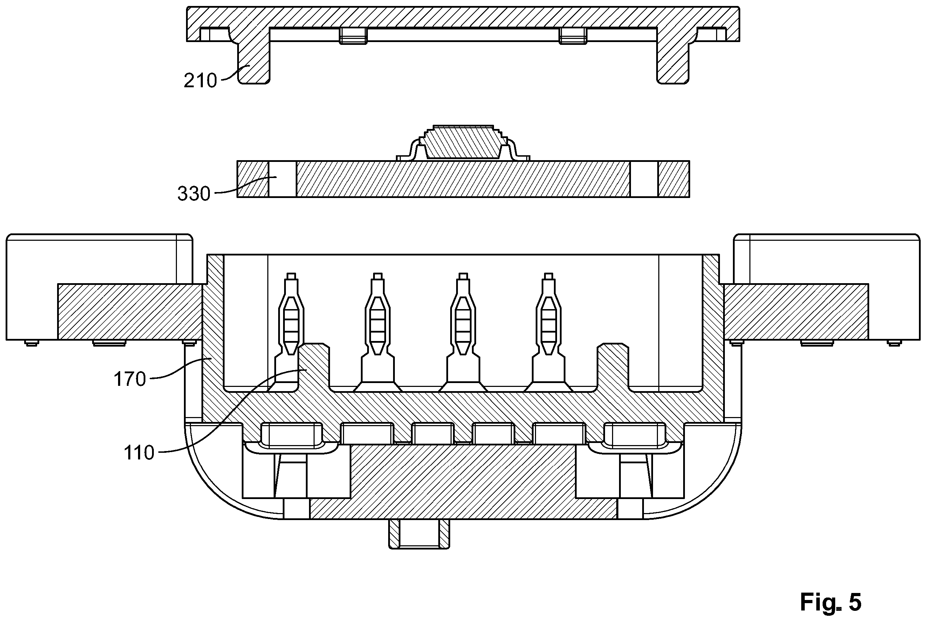

Further, Fig. 5 shows a sectional view of Fig. 4. In particular, the holder 110 is arranged in a central part of the housing, i.e. the holder 110 is arranged spaced apart from a circumferential wall 170 of the base 100. The cover 200 comprises a fixation means 210. The fixation means 210 is arranged closer to the walls 170 of the housing than the holder. Finally, the substrate comprises recesses 330, wherein the recesses 330 are arranged between the fixation means 210 and the holder 110.

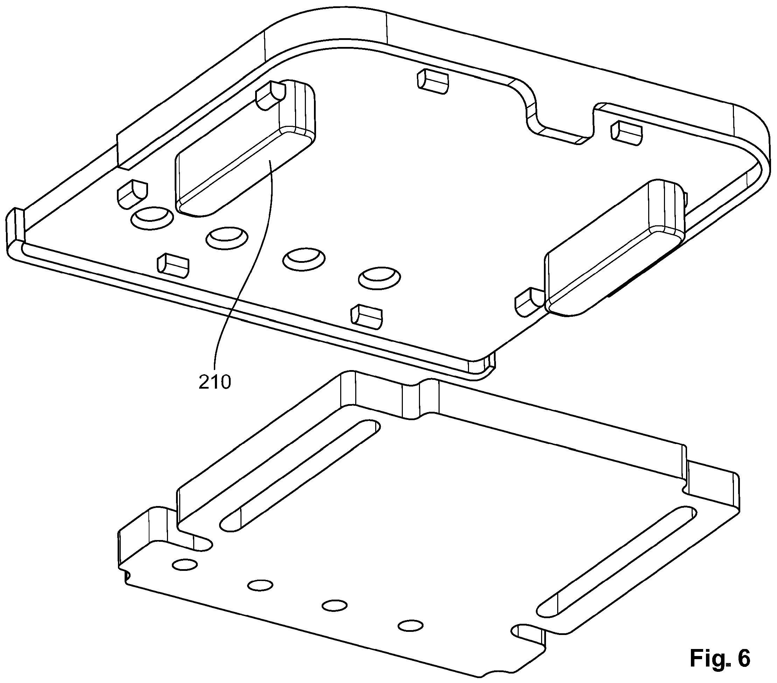

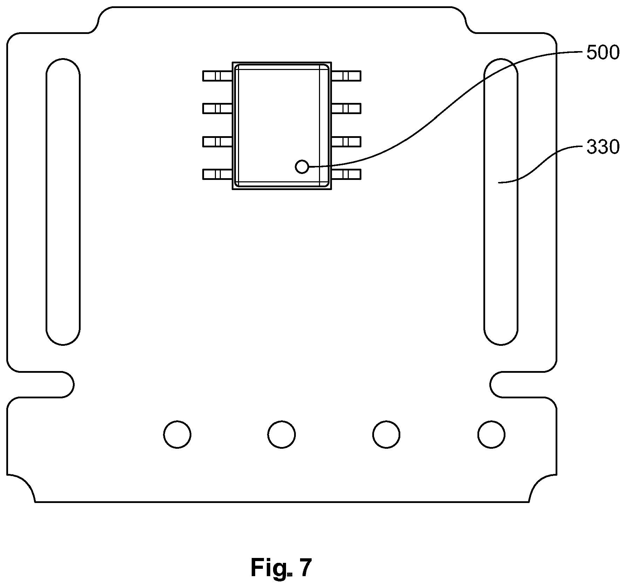

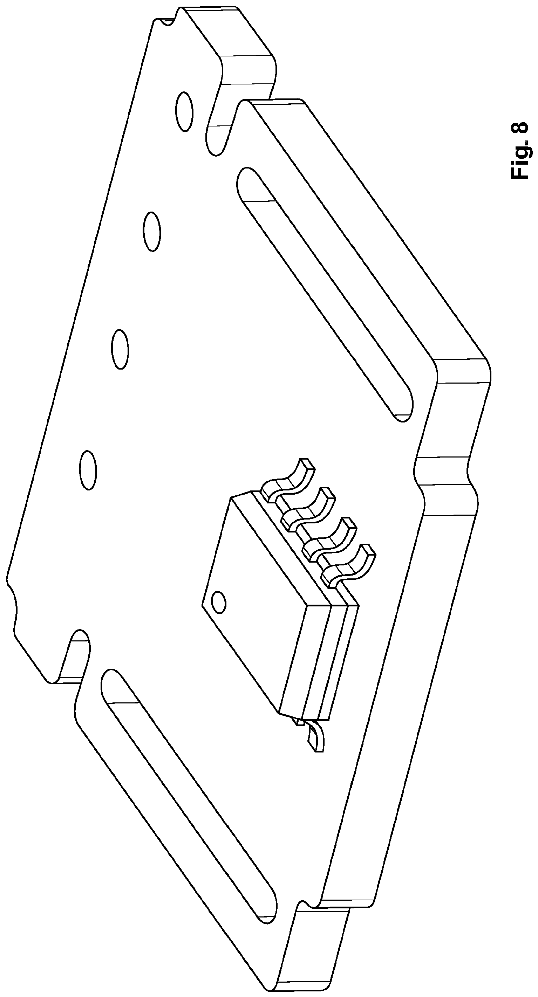

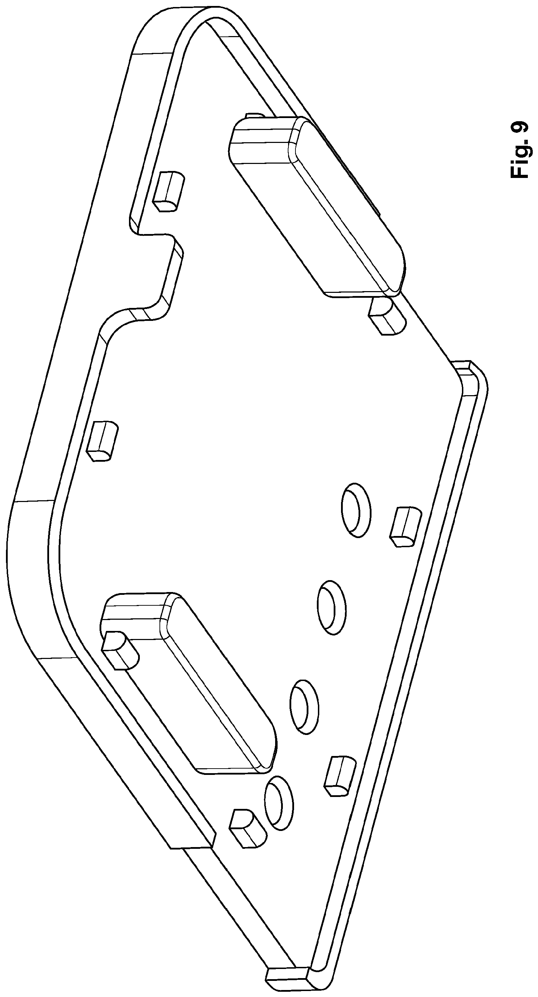

Further, Figs. 6 and 9 show that the fixation means 210 may have the shape of a rip. Further, Figs. 7 and 8 show that the substrate can have an electronic component 500 that is arranged in a central part to be hold by the holder. Further, an edge part or the substrate is separated from the central part by the recess 330 for protection the electronic component 500 form deformation.

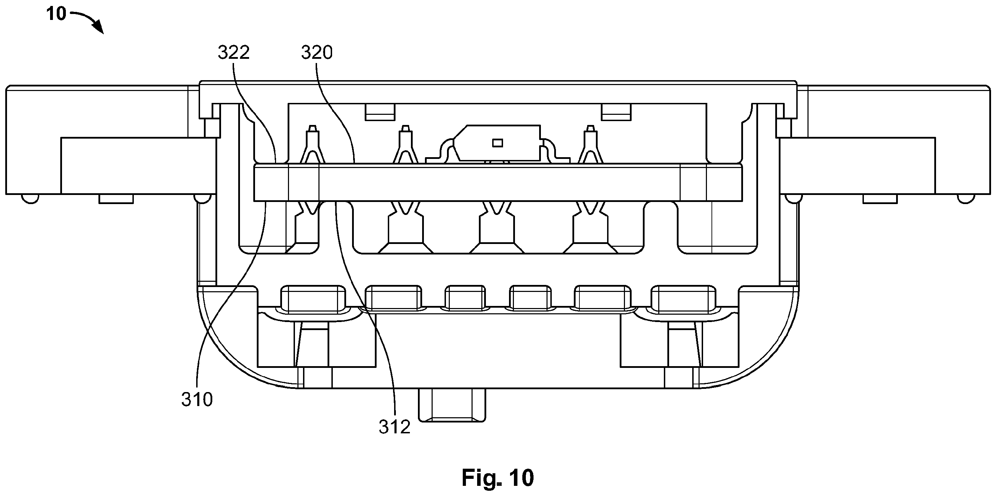

In particular, Fig. 10 is a sectional view of the kit 10 before closing the housing. In particular, the holding surface 310 and an opposing fixation surface 320 are plane. In particular, the holding part 312 is hold by the holder of the base. The fixation part 322 is still not being deformed by the fixation means of the cover. Thus, the substrate may have some tolerances to move in the chamber.

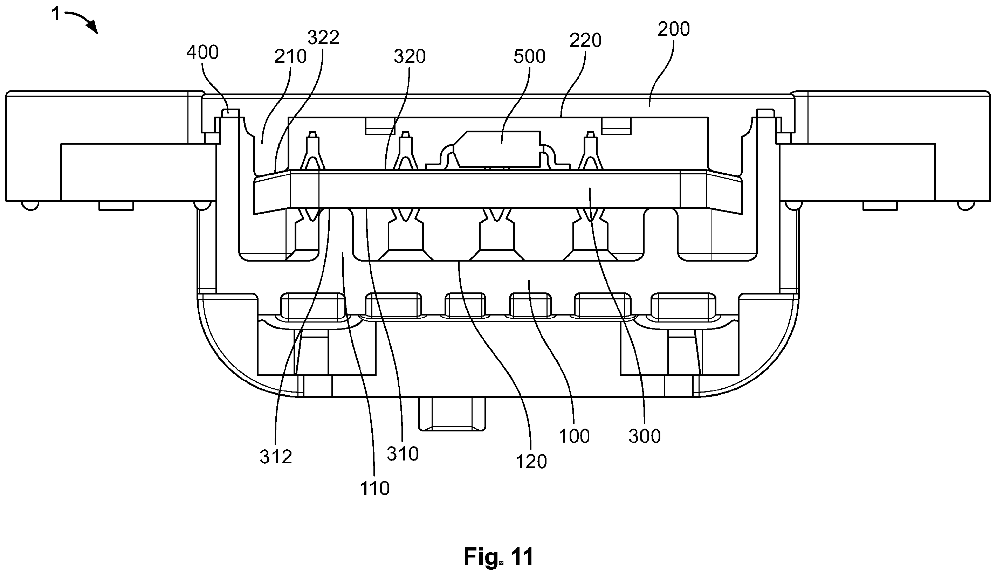

Further, Fig 11 shows a sectional view of the assembled part 1. In particular, the assembled part 1 is realized by providing the parts of the kit 10, as for example shown in Fig 10. The top surface 220 is moved towards the bottom surface 120.

For example, the movement is possible because the deformation part 400 is heated thereby melting the deformation part. By applying a force across the cover and the base, the cover 200 can be moved for a predetermined distance towards the base 100.

This movement causes that the fixation means 210 deforms the substrate 300. In particular, in view of the holder 110, the fixation part 322 of the substrate deforms. Thus, the fixation surface 320 is deformed. Similarly, the holding surface 310 deforms.

### REFERENCE NUMERALS

| **Reference Numeral** | **Description** |
|---|---|
| 1 | assembled part |
| 10 | kit |
| 20 | space |
| 100 | base |
| 110 | holder |
| 120 | bottom surface |
| 130 | gap |
| 150 | press-fit pin |
| 160 | opening |
| 170 | cicumferential wall |
| 200 | cover |
| 210 | fixation means |
| 220 | top surface |
| 260 | clip |
| 300 | substrate |
| 310 | holding surface |
| 312 | holding part |
| 320 | fixation surface |
| 322 | fixation part |
| 330 | recess |
| 350 | press-fit opening |
| 400 | deformable part, weld |
| 500 | electronic component |

## Claims

1. Housing assembly for enclosing and clamping a substrate (300) in a chamber, the housing assembly comprising
a base (100) having a protruding holder (110) for holding the substrate in the chamber, the holder protruding from the base so that the substrate is held at least partially spaced apart from a bottom surface of the base thereby forming a gap (130);
a cover (200) having a top surface (220) opposing the bottom surface, the cover for enclosing the substrate by moving the top surface towards the bottom surface;
wherein the cover comprises a fixation means (210) protruding from the cover in the direction of the bottom surface, the fixation means for deforming the substrate so that the substrate is clamped in the assembled housing when the cover encloses the substrate;
the fixation means (210) acting as a spring bias clamping the substrate in the chamber;
the housing assembly further comprising a deformable part (400) for sealing the assembled housing,
**characterized in that** the deformable part (400) is for being compressed in a direction of moving the top surface towards the bottom surface when moving the top surface towards the bottom surface, at least one of the base or the cover comprises the deformable part (400) and
the deformable part (400) being arranged at an edge of the base (100) or an edge of the cover (200) so that the deformable part (400) acts as a measure for defining the spring bias applied to the substrate in the assembled housing; and
wherein at least one of the cover and the base is transparent for guiding light to the deformable part for joining the base to the cover by radiation welding.

2. Housing assembly according to claim 1, wherein the deformable part comprises a thermoplastic material for melting when heated.

3. Housing assembly according to any of claims 1 to 2, wherein the fixation means protrudes from the top surface and/or the holder protrudes from the bottom surface.

4. Kit for an assembled part (1), the kit (10) comprising a substrate (300) for carrying an electronic component (500) and a housing assembly according to any of claims 1 to 3 for enclosing the substrate,
the substrate comprising a holding surface (310) and an opposing fixation surface (320), wherein the holding surface comprises a holding part (312) for being hold by the holder of the base and the fixation surface comprising a fixation part (322) for being deformed by the fixation means of the cover for fixing the substrate in the chamber.

5. Kit according to claim 4, wherein the substrate comprises an epoxy.

6. Kit according to claims 4 or 5, wherein the substrate comprises a recess (330), the recess being arranged abutting to the fixation part for protecting the electronic component from stress caused by deformation of the fixation part.

7. Kit according to claims 4 to 6, wherein the substrate comprises material having a lower coefficient of thermal expansion than the material comprised in the parts of the housing assembly.

8. Assembled part comprising a housing and a substrate (300) for holding an electronic component (500) in a chamber,
the substrate comprises a holding surface (310) and an opposing clamping surface (320),
the housing enclosing the substrate comprises a housing assembly according to any of claims 1 to 3, wherein the housing assembly comprises
a base (100) having a protruding holder (110) holding the substrate at a holder part (312) arranged at the holding surface (310), the holder protruding from the base so that the substrate is held at least partially spaced apart from a bottom surface (120) of the base thereby forming a gap between the substrate and the base;
a cover (200) having a top surface (220) opposing the bottom surface, the cover being mounted to the base thereby enclosing the substrate; and
wherein the cover comprises a fixation means (210) protruding from the cover in the direction of the bottom surface, the fixation means deforming a fixation part (322) arranged at the fixation surface so that the substrate is clamped in the assembled part (1).

9. Assembled part according to claim 8, wherein the housing comprises a weld (400), the weld sealing the chamber formed by the housing in which the substrate is clamped from the ingression of media.

10. Method for assembling a substrate in a housing, the method comprising the steps of:
holding a substrate in a base of the housing by a protruding holder for forming a gap between the substrate and a bottom surface of the base;
enclosing the substrate being hold in the base by moving a cover of the housing to the base thereby assembling the housing, the cover having a top surface (220) opposing the bottom surface;
providing a deformable part (400) for sealing the assembled housing;
wherein at least one of the base or the cover comprises the deformable part (400);
the deformable part (400) for being compressed in a direction of moving the top surface towards the bottom surface when moving the top surface towards the bottom surface, and the deformable part (400) being arranged at an edge of the base (100) or an edge of the cover (200) so that the deformable part acts as a measure for defining a spring bias applied to the substrate in the assembled housing;
deforming the substrate being hold in the base by moving a fixation means protruding from the cover in the direction of the bottom surface;
the fixation means acting as the spring bias clamping the substrate in the chamber; welding the base to the cover for assembling the housing by guiding radiation trough at least one the cover and the base portion for welding the base portion to the cover; and
applying an external force to at least one the cover and the base for moving the top surface to the bottom surface
wherein the steps of enclosing and deforming the substrate are executed simultaneously by moving the top surface of the cover in the direction of the bottom surface.

## Patentansprüche

1. Gehäuseanordnung zum Einschließen und Festklemmen eines Substrats (300) in einer Kammer, wobei die Gehäuseanordnung umfasst:
eine Basis (100) mit einem vorstehenden Halter (110) zum Halten des Substrats in der Kammer,
wobei der Halter von der Basis so vorsteht, dass das Substrat wenigstens teilweise von einer unteren Fläche der Basis beabstandet gehalten wird und so einen Zwischenraum (130) bildet;
eine Abdeckung (200) mit einer oberen Fläche (220), die der unteren Fläche gegenüberliegt, wobei die Abdeckung dazu dient, das Substrat durch Bewegen der oberen Fläche in Richtung der unteren Fläche einzuschließen;
wobei die Abdeckung eine Fixiereinrichtung (210) umfasst, die von der Abdeckung in der Richtung der unteren Fläche vorsteht, die Fixiereinrichtung dazu dient, das Substrat so zu verformen, dass das Substrat in dem zusammengesetzten Gehäuse festgeklemmt wird, wenn die Abdeckung das Substrat einschließt;
die Fixiereinrichtung (210) als eine Federvorspannung wirkt, durch die das Substrat in der Kammer festgeklemmt wird;
die Gehäuseanordnung des Weiteren einen verformbaren Teil (400) zum Abdichten des zusammengesetzten Gehäuses umfasst,
**dadurch gekennzeichnet, dass** der verformbare Teil (400) dazu dient, ihn in einer Richtung von Bewegung der oberen Fläche in Richtung der unteren Fläche bei Bewegung der oberen Fläche auf die untere Fläche zu zusammenzudrücken,
die Basis oder/und die Abdeckung den verformbaren Teil (400) umfasst/umfassen, und der verformbare Teil (400) an einem Rand der Basis (100) oder an einem Rand der Abdeckung (200) so angeordnet ist, dass der verformbare Teil (400) als ein Mittel dazu dient, die auf das Substrat in dem zusammengesetzten Gehäuse ausgeübte Federvorspannung zu bestimmen; und
wobei die Abdeckung oder/und die Basis transparent zum Leiten von Licht zu dem verformbaren Teil zum Verbinden der Basis mit der Abdeckung mittels Strahlschweißen ist/sind.

2. Gehäuseanordnung nach Anspruch 1, wobei der verformbare Teil ein thermoplastisches Material umfasst, das beim Erhitzen schmilzt.

3. Gehäuseanordnung nach einem der Ansprüche 1 bis 2, wobei die Fixiereinrichtung von der oberen Fläche vorsteht und/oder der Halter von der unteren Fläche vorsteht.

4. Bausatz für ein zusammengesetztes Teil (1), wobei der Bausatz (10) ein Substrat (300) zum Aufnehmen eines elektronischen Bauteils (500) sowie eine Gehäuseanordnung nach einem der Ansprüche 1 bis 3 zum Einschließen des Substrats umfasst,
das Substrat eine Haltefläche (310) sowie eine gegenüberliegende Fixierfläche (320) umfasst, wobei die Haltefläche einen Halteteil (312) umfasst, der von dem Halter der Basis gehalten wird, und die Fixierfläche einen fixiert Teil (322) umfasst, der durch die Fixiereinrichtung der Abdeckung verformt wird, um das Substrat in der Kammer zu fixieren.

5. Bausatz nach Anspruch 4, wobei das Substrat ein Epoxidharz umfasst.

6. Bausatz nach Anspruch 4 oder 5, wobei das Substrat eine Vertiefung (330) umfasst, die Vertiefung so angeordnet ist, dass sie an dem Fixierteil anlegt, um das elektronische Bauteil vor Belastung zu schützen, die durch Verformung des Fixierteils verursacht wird.

7. Bausatz nach den Ansprüchen 4 bis 6, wobei das Substrat ein Material umfasst, das einen niedrigeren Wärmeausdehnungskoeffizienten hat als das Material, das in den Teilen der Gehäuseanordnung enthalten ist.

8. Zusammengesetztes Teil, das ein Gehäuse und ein Substrat (300) zum Halten eines elektronischen Bauteils (500) in einer Kammer umfasst,
wobei das Substrat eine Haltefläche (310) sowie eine gegenüberliegende Klemmfläche (320) umfasst,
das Gehäuse, das das Substrat einschließt, eine Gehäuseanordnung nach einem der Ansprüche 1 bis 3 umfasst, wobei die Gehäuseanordnung umfasst:
eine Basis (100) mit einem vorstehenden Halter (110), der das Substrat an einem Halterteil (312) hält, das an der Haltefläche (310) angeordnet ist, wobei der Halter von der Basis so vorsteht, dass das Substrat wenigstens teilweise von einer unteren Fläche (120) der Basis beabstandet gehalten wird und so einen Zwischenraum zwischen dem Substrat und der Basis bildet;
eine Abdeckung (200) mit einer oberen Fläche (220), die der unteren Fläche gegenüberliegt, wobei die Abdeckung an der Basis angebracht ist und so das Substrat einschließt; und
wobei die Abdeckung eine Fixiereinrichtung (210) umfasst, die von der Abdeckung in der Richtung der unteren Fläche vorsteht, und die Fixiereinrichtung einen an der Fixierfläche angeordneten Fixierteil (322) so verformt, dass das Substrat in dem zusammengesetzten Teil (1) festgeklemmt wird.

9. Zusammengesetztes Teil nach Anspruch 8, wobei das Gehäuse eine Schweißverbindung (400) umfasst und die Schweißverbindung die Kammer, die durch das Gehäuse gebildet wird, in dem das Substrat festgeklemmt ist, gegen das Eindringen von Medien abdichtet.

10. Verfahren zum Einsetzen eines Substrats in einem Gehäuse, wobei das Verfahren die folgenden Schritte umfasst:
Halten eines Substrats in einer Basis des Gehäuses mittels eines vorstehenden Halters zum Ausbilden eines Zwischenraums zwischen dem Substrat und einer unteren Fläche der Basis;
Einschließen des in der Basis gehaltenen Substrats durch Bewegen einer Abdeckung des Gehäuses zu der Basis, um so das Gehäuse zusammenzusetzen, wobei die Abdeckung eine obere Fläche (220) aufweist, die der unteren Fläche gegenüberliegt;
Bereitstellen eines verformbaren Teils (400) zum Abdichten des zusammengesetzten Gehäuses;
wobei die Basis oder/und die Abdeckung den verformbaren Teil (400) umfasst/umfassen; wobei der verformbare Teil (400) dazu dient, ihn bei Bewegung der oberen Fläche in Richtung der unteren Fläche in einer Richtung von Bewegung der oberen Fläche auf die untere Fläche zu zusammenzudrücken, und der verformbare Teil (400) an einem Rand der Basis (100) oder einem Rand der Abdeckung (200) so angeordnet ist, dass der verformbare Teil als ein Mittel dazu dient, eine auf das Substrat in dem zusammengesetzten Gehäuse ausgeübte Federvorspannung zu bestimmen;
Verformen des in der Basis gehaltenen Substrats durch Bewegen einer von der Abdeckung vorstehenden Fixiereinrichtung in der Richtung der unteren Fläche;
wobei die Fixiereinrichtung als die Federvorspannung wirkt, durch die das Substrat in der Kammer festgeklemmt wird;
Anschweißen der Basis an der Abdeckung zum Zusammensetzen des Gehäuses durch Leiten von Strahlung durch die Abdeckung oder/und durch den Basisabschnitt hindurch zum Anschweißen des Basisabschnitts an der Abdeckung; sowie
Ausüben einer Kraft von außen auf die Abdeckung oder/und die Basis zum Bewegen der oberen Fläche zu der unteren Fläche,
wobei die Schritte des Einschließens und Verformens des Substrats gleichzeitig ausgeführt werden, indem die obere Fläche der Abdeckung in der Richtung der unteren Fläche bewegt wird.

## Revendications

1. Ensemble boîtier destiné à enfermer et à serrer un substrat (300) dans une chambre, l'ensemble boîtier comprenant:
une base (100) comportant un support en saillie (110) destiné à maintenir le substrat dans la chambre, le support faisant saillie à partir de la base de telle sorte que le substrat est maintenu au moins partiellement espacé d'une surface inférieure de la base, formant ainsi un espace (130);
un couvercle (200) comportant une surface supérieure (220) opposée à la surface inférieure, le couvercle étant prévu pour enfermer le substrat en déplaçant la surface supérieure vers la surface inférieure;
dans lequel le couvercle comprend un moyen de fixation (210) faisant saillie du couvercle en direction de la surface inférieure, le moyen de fixation étant prévu pour déformer le substrat de telle sorte que le substrat soit serré dans le boîtier assemblé lorsque le couvercle enferme le substrat;
le moyen de fixation (210) agissant comme un ressort de précontrainte serrant le substrat dans la chambre;
l'ensemble boîtier comprenant en outre une partie déformable (400) prévue pour sceller le boîtier assemblé,
**caractérisé en ce que** la partie déformable (400) est prévue pour être comprimée dans une direction de déplacement de la surface supérieure vers la surface inférieure lors du déplacement de la surface supérieure vers la surface inférieure, au moins l'un parmi la base et le couvercle comprenant la partie déformable (400) et la partie déformable (400) étant disposée au niveau d'un bord de la base (100) ou d'un bord du couvercle (200) de sorte que la partie déformable (400) sert à définir la précontrainte élastique appliquée au substrat dans le boîtier assemblé; et
dans lequel au moins l'un parmi le couvercle et la base est transparent pour guider la lumière vers la partie déformable afin de joindre la base au couvercle par soudage par rayonnement.

2. Ensemble boîtier selon la revendication 1, dans lequel la partie déformable comprend un matériau thermoplastique destiné à fondre lorsqu'il est chauffé.

3. Ensemble boîtier selon l'une quelconque des revendications 1 ou 2, dans lequel le moyen de fixation fait saillie depuis la surface supérieure et/ou le support fait saillie depuis la surface inférieure.

4. Kit pour pièce assemblée (1), le kit (10) comprenant un substrat (300) prévu pour supporter un composant électronique (500) et un ensemble boîtier selon l'une quelconque des revendications 1 à 3 destiné à enfermer le substrat,
le substrat comprenant une surface de maintien (310) et une surface de fixation opposée (320), dans lequel la surface de maintien comprend une partie de maintien (312) prévue pour être maintenue par le support de la base et la surface de fixation comprend une partie de fixation (322) prévue pour être déformée par le moyen de fixation du couvercle pour fixer le substrat dans la chambre.

5. Kit selon la revendication 4, dans lequel le substrat comprend une résine époxy.

6. Kit selon les revendications 4 ou 5, dans lequel le substrat comprend un évidement (330), l'évidement étant agencé en butée contre la partie de fixation pour protéger le composant électronique des contraintes causées par la déformation de la partie de fixation.

7. Kit selon les revendications 4 à 6, dans lequel le substrat comprend un matériau ayant un coefficient de dilatation thermique inférieur à celui du matériau compris dans les parties de l'ensemble boîtier.

8. Pièce assemblée comprenant un boîtier et un substrat (300) destiné à maintenir un composant électronique (500) dans une chambre,
le substrat comprend une surface de maintien (310) et une surface de serrage opposée (320),
le boîtier renfermant le substrat comprend un ensemble boîtier selon l'une quelconque des revendications 1 à 3, dans lequel l'ensemble boîtier comprend une base (100) comportant un support en saillie (110) retenant le substrat au niveau d'une partie de support (312) disposée au niveau de la surface de retenue (310), le support faisant saillie de la base de sorte que le substrat est retenu au moins partiellement espacé d'une surface inférieure (120) de la base, formant ainsi un espace entre le substrat et la base;
un couvercle (200) comportant une surface supérieure (220) opposée à la surface inférieure, le couvercle étant monté sur la base de manière à enfermer le substrat; et
dans lequel le couvercle comprend un moyen de fixation (210) faisant saillie du couvercle en direction de la surface inférieure, le moyen de fixation déformant une partie de fixation (322) disposée au niveau de la surface de fixation de manière à ce que le substrat soit serré dans la pièce assemblée (1).

9. Pièce assemblée selon la revendication 8, dans laquelle le boîtier comprend une soudure (400), la soudure scellant la chambre formée par le boîtier dans laquelle le substrat est serré contre toute intrusion de fluides.

10. Procédé d'assemblage d'un substrat dans un boîtier, le procédé comprenant les étapes consistant à:
maintenir un substrat dans une base du boîtier à l'aide d'un support en saillie afin de former un espace entre le substrat et une surface inférieure de la base;
enfermer le substrat maintenu dans la base en déplaçant un couvercle du boîtier vers la base, assemblant ainsi le boîtier, le couvercle ayant une surface supérieure (220) opposée à la surface inférieure ;
constituer une partie déformable (400) pour sceller le boîtier assemblé;
dans lequel au moins l'un parmi la base et le couvercle comprend la partie déformable (400);
la partie déformable (400) étant prévue pour être comprimée dans une direction de déplacement de la surface supérieure vers la surface inférieure lorsque la surface supérieure est déplacée vers la surface inférieure, et la partie déformable (400) étant disposée au niveau d'un bord de la base (100) ou d'un bord du couvercle (200) de sorte que la partie déformable permet de définir une précontrainte élastique appliquée au substrat dans le boîtier assemblé;
déformer le substrat maintenu dans la base en déplaçant un moyen de fixation faisant saillie du couvercle dans la direction de la surface inférieure;
le moyen de fixation agissant comme la précontrainte élastique serrant le substrat dans la chambre;
souder la base au couvercle pour assembler le boîtier en guidant un rayonnement à travers au moins l'un parmi le couvercle et la partie de base pour souder la partie de base au couvercle; et
appliquer une force externe sur au moins l'un parmi le couvercle et la base pour déplacer la surface supérieure vers la surface inférieure
dans lequel les étapes consistant à enfermer et à déformer le substrat sont exécutées simultanément en déplaçant la surface supérieure du couvercle vers la surface inférieure.
